# FASCICULE DE BREVET EUROPEEN

(11) **EP 3 574 501 B1**
(45) Date de publication et mention de la délivrance du brevet: **16.11.2022**
(21) Numéro de dépôt: 17816803.5
(22) Date de dépôt: 14.12.2017
(51) Int. Cl.: G11C 16/34, H04N 21/433

(54) **PROCÉDÉ D'ENREGISTREMENT ADAPTATIF AU TAUX D'USURE DU SUPPORT DE STOCKAGE**
VERFAHREN ZUR AUFZEICHNUNG, DAS AN DEN VERSCHLEISSGRAD DES SPEICHERMEDIUMS ANGEPASST IST
METHOD OF RECORDING ADAPTIVE TO THE DEGREE OF WEAR OF THE STORAGE MEDIUM

(30) Priorité: 26.01.2017 FR 1750651
(43) Date de publication de la demande: 04.12.2019
(73) Titulaire: Sagemcom Broadband SAS, 92500 Rueil-Malmaison (FR)
(72) Inventeur: BELLANGER, Julien, 92500 Rueil Malmaison (FR); CAMMAS, Anthony, 92500 Rueil Malmaison (FR)
(74) Mandataire: Lavaud, Thomas
(86) Numéro de dépôt international: PCT/EP2017/082904
(87) Numéro de publication internationale: WO 2018/137845

(56) Documents cités:
- EP-A1- 2 709 110
- US-A1- 2005 080 497
- US-A1- 2008 147 910
- US-B2- 9 135 185

## Description

L'invention concerne le domaine des procédés d'enregistrement utilisés pour mettre en œuvre une fonction de type contrôle du direct.

### ARRIERE PLAN DE L'INVENTION

Le contrôle du direct (ou *time shifting*, en anglais) permet de regarder ou d'écouter un programme diffusé en léger différé par rapport à sa diffusion.

Le contrôle du direct consiste à enregistrer un flux sur un support de stockage (par exemple sur un disque dur ou sur un disque SSD, pour *Solid-State Drive*, ou sur une mémoire eMMC, pour *embedded Multi-Media Controller*) en mettant en œuvre un *buffer* circulaire. Lorsque le *buffer* circulaire est plein, les données du flux les plus anciennes sont remplacées par les données du flux les plus récentes. La taille du *buffer* circulaire ainsi que le débit du flux définissent une durée disponible de contrôle du direct.

Le flux peut être un flux audio, un flux vidéo, ou bien un flux audio et vidéo.

Le flux peut être diffusé de nombreuses manières, et par exemple via un satellite, via la TNT (pour Télévision Numérique Terrestre), via un câble ou via un réseau IP (pour *Internet Protocol*). La diffusion via le réseau IP utilise elle-même des techniques de *streaming*, de HLS (pour *HTTP Live Streaming*), de *progressive download*, etc.

Le flux peut être reçu par différents types de clients récepteurs, et par exemple par un boîtier décodeur (ou set-*top box*), un ordinateur, une tablette, un téléphone mobile, etc.

On note que d'autres systèmes fonctionnent selon un principe similaire, et notamment des systèmes de surveillance vidéo.

L'une des difficultés auxquelles sont confrontés les concepteurs de solutions de contrôle du direct concerne l'usure du support de stockage.

Les supports de stockage utilisés pour le contrôle du direct, et notamment ceux qui comportent de la mémoire flash, présentent un nombre de cycles d'écriture/effacement généralement relativement faible. La mémoire flash comprend une réserve de blocs de mémoire vierges. Lorsque le support de stockage commence à s'user, la réserve de blocs de mémoire vierges s'amenuise. Le logiciel stocké dans le support de stockage aura donc moins de blocs de mémoire vierges à disposition pour effectuer des écritures telles que des préférences utilisateur, ou bien pour réaliser une mise à jour du logiciel.

Le document EP 2 709 110 A1 décrit une méthode pour évaluer l'usure d'un support de stockage.

### OBJET DE L'INVENTION

L'invention a pour objet de réduire une usure prématurée d'un support de stockage due à l'utilisation d'une fonction de type contrôle du direct.

### RESUME DE L'INVENTION

En vue de la réalisation de ce but, on propose un procédé d'enregistrement d'un flux reçu tel qu'un flux audio et vidéo, utilisé pour mettre en œuvre une fonction de type contrôle du direct, le procédé d'enregistrement comportant les étapes :
- d'évaluer une usure d'un support de stockage destiné à enregistrer le flux reçu ;
- de calculer en fonction de l'usure un débit optimal de flux permettant d'augmenter une durée de vie du support de stockage ;
- d'adapter le flux reçu pour l'enregistrer au débit optimal de flux.

En adaptant le flux reçu au débit optimal de flux, on augmente la durée de vie du support de stockage.

On propose aussi un boîtier décodeur comportant des moyens de traitement agencés pour mettre en œuvre le procédé d'enregistrement qui vient d'être décrit.

On propose de plus un programme d'ordinateur comprenant des instructions pour mettre en œuvre, par un équipement de type boîtier décodeur, le procédé d'enregistrement qui vient d'être décrit.

On propose en outre des moyens de stockage qui stockent un programme d'ordinateur comprenant des instructions pour mettre en œuvre, par un équipement de type boîtier décodeur, le procédé d'enregistrement qui vient d'être décrit.

D'autres caractéristiques et avantages de l'invention ressortiront à la lecture de la description qui suit d'un mode de réalisation particulier non limitatif de l'invention.

### BREVE DESCRIPTION DES DESSINS

Il sera fait référence aux dessins annexés, parmi lesquels :
- la figure 1 représente des étapes du procédé d'enregistrement selon l'invention ;
- la figure 2 est un graphique représentant une courbe d'un débit optimal de flux en fonction d'une usure d'un support de stockage, le débit optimal de flux étant calculé selon une première méthode ;
- la figure 3 est un graphique représentant une courbe d'un débit optimal de flux en fonction d'une usure d'un support de stockage, le débit optimal de flux étant calculé selon une deuxième méthode ;
- la figure 4 est un graphique représentant une courbe d'un débit optimal de flux en fonction d'une usure d'un support de stockage, le débit optimal de flux étant calculé selon une troisième méthode ;
- la figure 5 est un graphique représentant des courbes du rapport entre la durée de vie du support de stockage alors que le procédé d'enregistrement selon l'invention est mis en œuvre et alors que le procédé d'enregistrement selon l'invention n'est pas mis en œuvre, en fonction de l'usure du support de stockage, pour la première méthode, la deuxième méthode et la troisième méthode.

### DESCRIPTION DETAILLEE DE L'INVENTION

Le procédé d'enregistrement selon l'invention est ici mis en œuvre dans un boîtier décodeur.

Le boîtier décodeur comprend des moyens de traitement comprenant un processeur, un support de stockage, un port Ethernet, un port HDMI et un port infrarouge.

Le boîtier décodeur est relié à un réseau de diffusion, en l'occurrence au réseau internet, via le port Ethernet. Le boîtier décodeur est par ailleurs relié à un téléviseur via le port HDMI, et est commandé par une télécommande via le port infrarouge.

Le boîtier décodeur reçoit d'un serveur externe, via le port Ethernet, un flux reçu, qui est en l'occurrence un flux audio et vidéo. Le boîtier décodeur transforme le flux reçu en un flux audio et vidéo compatible avec le téléviseur. Le flux audio et vidéo est transmis au téléviseur via le port HDMI, et est diffusé sous la forme de programmes diffusés sur l'écran du téléviseur.

Un utilisateur qui regarde un programme diffusé et qui décide d'utiliser la fonction de contrôle du direct peut commander le boîtier décodeur grâce à la télécommande pour que celui-ci mette en œuvre une fonction de contrôle du direct. Le boîtier décodeur enregistre alors le flux audio et vidéo dans le support de stockage pour permettre à l'utilisateur de regarder le programme diffusé en différé.

Le procédé d'enregistrement selon l'invention est mis en œuvre à chaque sortie d'un mode de veille du boîtier décodeur. Il serait aussi possible de mettre en œuvre le procédé d'enregistrement selon l'invention à des moments différents, par exemple à chaque démarrage du boîtier décodeur, à chaque fois qu'un utilisateur utilise la fonction de contrôle du direct, ou bien à intervalles temporels prédéfinis (chaque jour, chaque semaine, chaque mois, etc.).

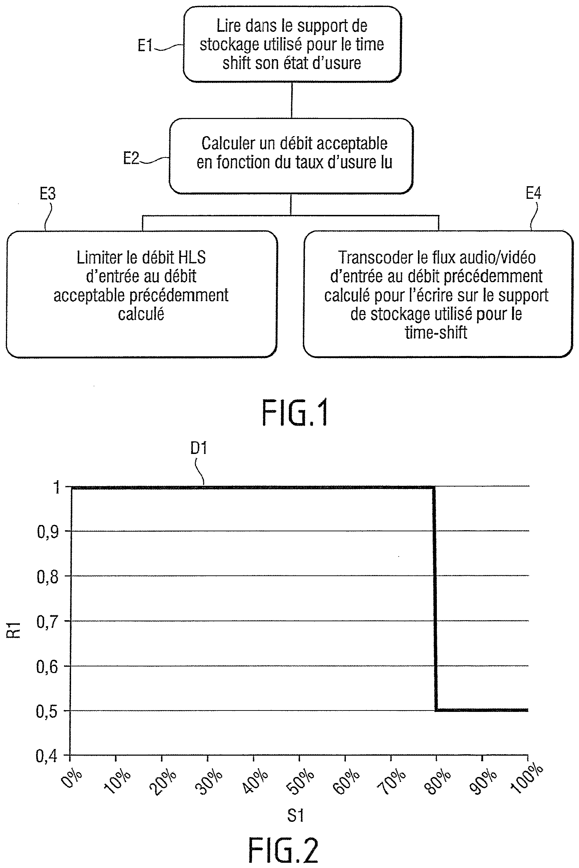

En référence à la figure 1, le procédé d'enregistrement selon l'invention consiste tout d'abord à évaluer une usure du support de stockage (étape E1). L'évaluation de l'usure du support de stockage comprend une acquisition, dans le support de stockage, d'un paramètre d'usure représentatif de l'usure du support de stockage. Le paramètre d'usure est ici un taux d'usure, sans unité, compris entre 0 et 100%. Le support de stockage stocke l'information correspondant au taux d'usure dans un registre interne. Le taux d'usure est ainsi accessible par lecture du registre interne.

Ainsi, lorsque le support de stockage comprend une mémoire eMMC, l'information correspondant au taux d'usure est stockée dans les registres internes *ExtendedCSD* 268 et 269. Ces registres internes sont définis selon la norme *JEDEC JESD84,* et indiquent le taux d'usure par paliers de 10%.

D'autres supports de stockage permettent par exemple de lire le nombre de cycles d'écriture/effacement. Dans ce cas, le paramètre d'usure est le nombre de cycles d'écriture/effacement.

On note qu'il est possible d'optimiser l'évaluation de l'usure du support de stockage en adaptant le paramètre d'usure à des conditions d'usure réelles du support de stockage. En effet, les fabricants de supports de stockage ont tendance à définir les paramètres d'usure, tels que le taux d'usure précédemment évoqué, en prenant une marge de sécurité. L'usure évaluée est ainsi supérieure à l'usure réelle du support de stockage. Il est alors possible, lors de la mise en œuvre du procédé d'enregistrement selon l'invention, de réduire le paramètre d'usure pour que celui-ci corresponde à une usure réelle du support de stockage.

Le procédé d'enregistrement selon l'invention consiste ensuite à calculer en fonction de l'usure un débit optimal de flux permettant d'augmenter une durée de vie du support de stockage (étape E2). Le débit optimal de flux est un débit inférieur ou égal au débit du flux reçu, qui permet d'optimiser à la fois la qualité de la diffusion en différé du programme diffusé et la réduction de l'usure du support de stockage.

Le débit optimal de flux peut être calculé selon plusieurs méthodes.

Selon une première méthode et en référence à la figure 2, le débit optimal de flux D1 est égal au débit du flux reçu lorsque l'usure du support de stockage (en l'occurrence, le taux d'usure) est inférieure ou égale à un seuil d'usure prédéterminé S1, et est égal au débit du flux reçu multiplié par un rapport de limitation prédéterminé R1 lorsque l'usure du support de stockage (en l'occurrence, le taux d'usure) est supérieure au seuil d'usure prédéterminé S1, le rapport de limitation prédéterminé R1 étant compris entre 0 et 1.

Sur la figure 2, le seuil d'usure prédéterminé S1 est égal à 80%, et le rapport de limitation prédéterminé R1 est égal à 0,5.

Cette première méthode permet à l'utilisateur de bénéficier d'une diffusion différée du programme diffusé avec un débit maximum (soit une qualité de diffusion maximale) pendant une période importante.

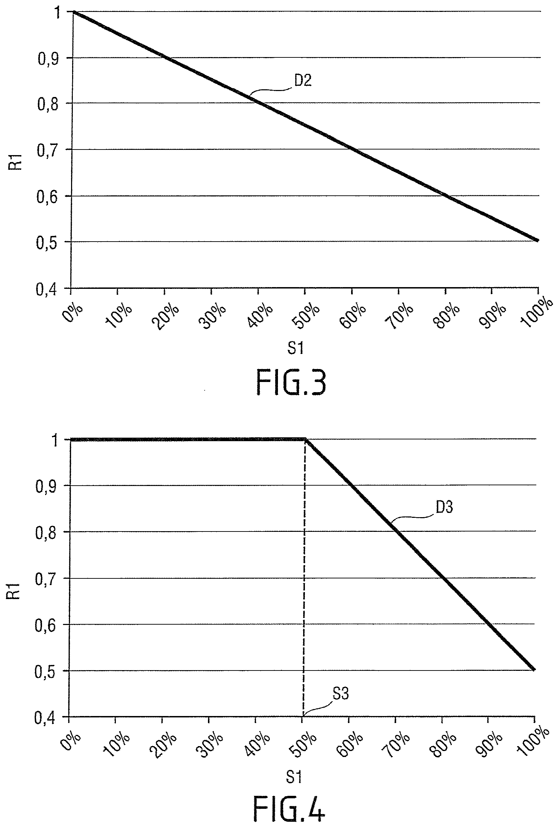

Selon une deuxième méthode et en référence à la figure 3, le débit optimal de flux D2 est une fonction linéaire de l'usure du support de stockage (en l'occurrence, du taux d'usure).

Cette deuxième méthode permet à l'utilisateur de bénéficier d'une diffusion différée du programme diffusé avec un rapport entre le débit (ou la qualité de diffusion) et la durée de vie du support de stockage (ou la réduction de l'usure du support de stockage) le plus important.

Selon une troisième méthode et en référence à la figure 4, le débit optimal de flux D3 est égal au débit du flux reçu lorsque l'usure du support de stockage est inférieure ou égal à un seuil d'usure prédéterminé S3, et est une fonction linéaire de l'usure du support de stockage à partir du moment où celle-ci atteint un seuil d'usure prédéterminé.

Sur la figure 4, le seuil d'usure prédéterminé S3 est compris entre 50% et 60%.

On vient ainsi de présenter trois méthodes pour calculer le débit optimal de flux.

Le choix entre l'une de ces trois méthodes peut par exemple être fait au moment de la fabrication du boîtier décodeur (c'est à dire avant qu'il ne soit installé chez l'utilisateur), ou bien suite à une mise à jour du logiciel du boîtier décodeur, ou bien par l'utilisateur lui-même, etc.

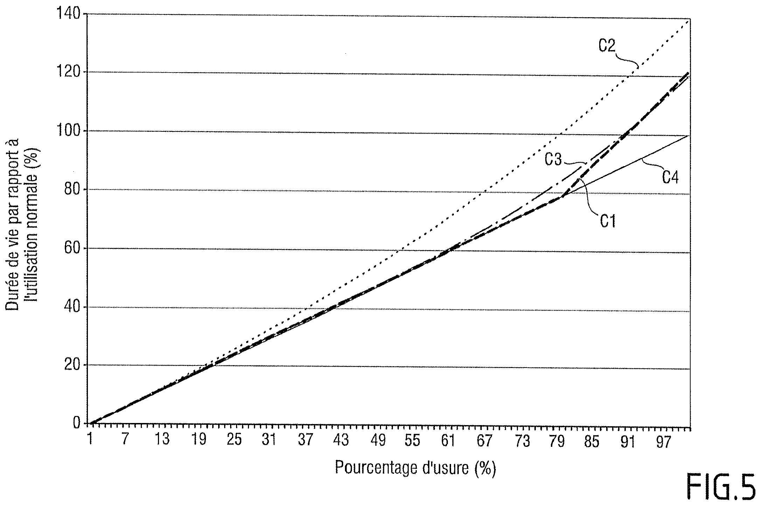

Le rapport entre la durée de vie du support de stockage alors que le procédé d'enregistrement selon l'invention est mis en œuvre, et entre la durée de vie du support de stockage alors que le procédé d'enregistrement selon l'invention n'est pas mis en œuvre, en fonction de l'usure du support de stockage, peut être observée sur la figure 5 : la courbe C1 correspond à la première méthode, la courbe C2 à la deuxième méthode, et la courbe C3 à la troisième méthode. La courbe C4, utilisée comme référence, correspond au cas où le procédé d'enregistrement selon l'invention n'est pas mis en œuvre.

Le procédé d'enregistrement selon l'invention consiste ensuite à d'adapter le flux reçu pour obtenir un flux enregistré dans le support de stockage présentant le débit optimal de flux.

Une première méthode pour adapter le flux reçu consiste ajuster le débit du flux reçu pour que le débit du flux reçu et donc du flux enregistré soit égal au débit optimal de flux (étape E3).

Lorsque le procédé d'enregistrement selon l'invention n'est pas mis en œuvre, le serveur externe transmet un flux audio et vidéo en utilisant les mécanismes de transmission décrits ci-après.

Le serveur externe, lorsqu'il transmet un flux audio et vidéo, découpe la vidéo correspondante en segments d'une durée de quelques secondes (typiquement, 2 à 10 secondes). Chaque segment est stocké sur le serveur externe en plusieurs versions, chaque version présentant un débit différent des débits des autres versions. Le serveur externe envoie alors au boîtier décodeur une liste des segments de la vidéo et des débits dans lesquels chaque segment est disponible. Le boîtier décodeur demande les segments au serveur externe l'un après l'autre. Pour chaque segment, le boîtier décodeur spécifie un débit cible avec lequel il souhaite que le segment lui soit envoyé. Le serveur externe envoie alors au boîtier décodeur la version du segment demandé correspondant au débit spécifié par le boîtier décodeur.

Le boîtier décodeur mesure alors le temps mis pour recevoir chaque segment, et ajuste le débit cible qu'il demande pour les segments suivants en fonction du temps mis pour recevoir les segments passés. Ainsi, si le temps mis pour recevoir un segment est plus long que la durée du segment, alors le boîtier décodeur diminue le débit cible demandé. Au contraire, si le temps mis pour recevoir un segment est plus court que la durée du segment, alors le boîtier décodeur augmente le débit cible demandé.

Dans le cadre de la mise en œuvre du procédé d'enregistrement selon l'invention, le boîtier décodeur spécifie au serveur externe un débit cible. Le débit cible est égal au débit optimal de flux lorsque celui-ci est inférieur ou égal à un débit maximum de transfert du réseau de diffusion sur lequel chemine le flux reçu, et le débit cible est égal au débit maximum de transfert du réseau de diffusion lorsque le débit optimal de flux est supérieur au débit maximum de transfert du réseau de diffusion.

Par exemple, lorsque le flux audio et vidéo présente un débit maximum de 10Mo/s, si le débit optimal de flux est égal à 5Mo/s et que les performances réseaux permettent un débit maximum de transfert de 10Mo/s, le débit cible qui sera demandé au serveur externe par le boîtier décodeur sera égal au débit optimal de flux, soit à 5Mo/s.

Par contre, lorsque le flux audio et vidéo présente un débit maximum de 10Mo/s, si le débit optimal de flux est égal à 10Mo/s et que les performances réseaux permettent un débit de transfert maximum de 5Mo/s, le débit cible qui sera demandé au serveur externe par le boîtier décodeur sera égal au débit de transfert maximum permis par les performances du réseau, soit à 5Mo/s.

Il existe cependant des situations dans lesquelles le réseau de diffusion ne permet pas au boîtier décodeur d'ajuster le débit du flux reçu. Ainsi, sur un réseau de diffusion par satellite, l'émetteur envoie un unique flux audio et vidéo et le boîtier décodeur n'a aucun moyen de modifier le flux reçu.

Dans ce cas, si l'utilisateur souhaite regarder un programme diffusé en direct, sans utiliser la fonction de contrôle du direct, le boîtier décodeur ne modifie pas le débit du flux reçu. L'utilisateur bénéficie donc de la qualité maximale de diffusion.

Par contre, si l'utilisateur souhaite utiliser la fonction de contrôle du direct et que le débit du flux reçu est supérieur au débit optimal de flux, une deuxième méthode pour adapter le flux reçu consiste à transcoder le flux reçu pour obtenir un flux enregistré dans le support de stockage dont le débit est égal au débit optimal de flux (étape E4).

Plusieurs techniques peuvent être utilisées pour transcoder le flux reçu selon cette deuxième méthode.

Le transcodage peut consister à agir sur un flux audio compris dans le flux reçu, sur un flux vidéo compris dans le flux reçu, ou bien à la fois sur le flux audio et sur le flux vidéo.

L'action sur le flux audio peut consister, lorsque le flux audio comporte plusieurs pistes audio correspondant à plusieurs langues, à supprimer une ou des pistes correspondant à des langues non souhaitées par l'utilisateur.

L'action sur le flux audio peut aussi consister à réduire le nombre de canaux des pistes audio. Par exemple, si l'une des pistes audio contient 6 canaux en « mode multicanal 5.1 », le boîtier décodeur peut remplacer cette piste audio par une piste stéréo comportant 2 canaux.

L'action sur le flux audio peut aussi consister à utiliser un codec pour compresser le flux audio, à ajuster un taux de compression d'un codec utilisé, ou bien à modifier un codec utilisé pour utiliser un codec offrant un meilleur taux de compression.

L'action sur le flux vidéo peut consister à réduire la résolution d'images du flux vidéo. Il est par exemple possible de passer d'une résolution du format d'image numérique dit « 4K » (3840×2160 pixels) à une résolution du format d'image numérique dit « HD » (1920×1080 pixels) en utilisant un redimensionnement bilinéaire.

L'action sur le flux vidéo peut aussi consister à utiliser un codec pour compresser le flux vidéo, à ajuster un taux de compression d'un codec utilisé, ou bien à modifier un codec utilisé pour utiliser un codec offrant un meilleur taux de compression.

Bien sûr, toutes ces actions ou certaines de ces actions sur le flux audio et sur le flux vidéo peuvent être combinées.

On vient ainsi de présenter deux méthodes pour adapter le flux reçu pour obtenir un flux enregistré dans le support de stockage présentant le débit optimal de flux : une première méthode consistant à ajuster le débit du flux reçu, et une deuxième méthode consistant à transcoder le flux reçu.

On note que la première méthode présente l'inconvénient de ne pouvoir être mise en œuvre que lorsqu'il est possible d'agir sur le flux reçu, et que la deuxième méthode présente l'avantage de ne pas réduire la qualité de la diffusion lorsque la fonction de contrôle du direct n'est pas utilisée.

Le choix entre la première méthode et la deuxième méthode peut par exemple être fait au moment de la fabrication du boîtier décodeur (c'est à dire avant qu'il ne soit installé chez l'utilisateur), ou bien en fonction du réseau de diffusion auquel le boîtier décodeur est connecté, ou bien suite à une mise à jour du logiciel du boîtier décodeur, ou bien par l'utilisateur lui-même, etc. Ceci est aussi valable pour les différentes techniques possiblement utilisées pour transcoder le flux reçu.

Bien entendu, l'invention n'est pas limitée au mode de réalisation décrit mais englobe toute variante entrant dans le champ de l'invention telle que définie par les revendications.

Bien que l'on ait indiqué ici que le flux est reçu par un boîtier décodeur, il est possible d'utiliser un autre client récepteur, par exemple un ordinateur, une tablette, un téléphone mobile, etc.

Le flux reçu n'est pas nécessairement un flux audio et vidéo, mais peut être par exemple un flux audio (uniquement) ou un flux vidéo (uniquement).

On a indiqué ici que le support de stockage comprend une mémoire eMMC, mais l'invention s'applique bien sûr à tout type de support de stockage.

On a utilisé ici comme paramètre d'usure représentatif de l'usure du support de stockage un taux d'usure compris entre 0 et 100%. Il est parfaitement possible d'utiliser un paramètre d'usure différent, par exemple un taux d'usure compris entre 0 et 1, ou bien un nombre de cycles d'écriture/effacement.

Dans la première méthode, la deuxième méthode et la troisième méthode pour calculer le débit de flux optimal, le seuil d'usure prédéterminé et le rapport prédéterminé peuvent être différents des valeurs citées. Le seuil d'usure prédéterminé peut par exemple être égal à 50%, 60%, 75%, 80%, 85%, ou bien être compris entre ces valeurs.

L'invention ne s'applique pas uniquement à la mise en œuvre d'une fonction de contrôle du direct, mais à toute fonction qui utilise un principe similaire (par exemple, à une fonction de surveillance vidéo qui permet de visionner en différé une bande vidéo de surveillance).

## Revendications

1. Procédé d'enregistrement d'un flux reçu tel qu'un flux audio et/ou vidéo, le procédé d'enregistrement comportant les étapes :
- d'évaluer une usure d'un support de stockage destiné à enregistrer le flux reçu, l'évaluation de l'usure comprenant l'étape d'acquérir, dans le support de stockage, un paramètre d'usure représentatif de l'usure du support de stockage ;
- de calculer en fonction de l'usure un débit optimal de flux permettant d'augmenter une durée de vie du support de stockage, le débit optimal de flux étant un débit inférieur ou égal au débit du flux reçu, qui permet d'optimiser à la fois une qualité d'une diffusion en différé d'un programme diffusé et une réduction de l'usure du support de stockage ;
- d'adapter le flux reçu pour l'enregistrer au débit optimal de flux.

2. Procédé d'enregistrement selon la revendication 1, comprenant en outre l'étape d'adapter le paramètre d'usure pour qu'il caractérise mieux une usure réelle du support de stockage.

3. Procédé d'enregistrement selon la revendication 1, dans lequel le paramètre d'usure est un taux d'usure compris entre 0 et 1 ou entre 0 et 100%.

4. Procédé d'enregistrement selon la revendication 1, dans lequel le paramètre d'usure est un nombre de cycles d'écriture/effacement.

5. Procédé d'enregistrement selon la revendication 1, dans lequel le débit optimal de flux est égal au débit du flux reçu lorsque l'usure du support de stockage est inférieure ou égale à un seuil d'usure prédéterminé, et est égal au débit du flux reçu multiplié par un rapport de limitation prédéterminé lorsque l'usure du support de stockage est supérieure au seuil d'usure prédéterminé, le rapport de limitation prédéterminé étant compris entre 0 et 1.

6. Procédé d'enregistrement selon la revendication 1, dans lequel le débit optimal de flux est une fonction linéaire de l'usure du support de stockage.

7. Procédé d'enregistrement selon la revendication 1, dans lequel le débit optimal de flux est une fonction linéaire de l'usure du support de stockage jusqu'à ce que celle-ci atteigne un seuil d'usure prédéterminé.

8. Procédé d'enregistrement selon la revendication 1, dans lequel l'adaptation du flux reçu consiste à ajuster un débit du flux reçu pour que le débit du flux reçu et donc du flux enregistré soit égal au débit optimal de flux.

9. Procédé d'enregistrement selon la revendication 8, dans lequel l'ajustement du débit du flux reçu consiste à spécifier un débit cible à un serveur externe qui génère le flux.

10. Procédé d'enregistrement selon la revendication 9, dans lequel le débit cible est égal au débit optimal de flux lorsque celui-ci est inférieur ou égal à un débit maximum de transfert d'un réseau sur lequel chemine le flux reçu, et dans lequel le débit cible est égal au débit maximum de transfert du réseau lorsque le débit optimal de flux est supérieur au débit maximum de transfert du réseau.

11. Procédé d'enregistrement selon la revendication 1, dans lequel l'adaptation du flux reçu consiste à transcoder le flux reçu pour obtenir le flux enregistré.

12. Procédé d'enregistrement selon la revendication 11, dans lequel le transcodage consiste à agir sur un flux audio compris dans le flux reçu.

13. Procédé d'enregistrement selon la revendication 12, dans lequel l'action sur le flux audio consiste à supprimer une piste audio correspondant à une langue non souhaitée, et/ou à réduire un nombre de canaux de pistes audio, et /ou à ajuster un taux de compression d'un codec, et/ou à modifier un codec utilisé.

14. Procédé d'enregistrement selon la revendication 11, dans lequel le transcodage consiste à agir sur un flux vidéo compris dans le flux reçu.

15. Procédé d'enregistrement selon la revendication 14, dans lequel l'action sur le flux vidéo consiste à réduire la résolution d'images du flux vidéo, et/ou à ajuster un taux de compression d'un codec, et/ou à modifier un codec utilisé.

16. Procédé d'enregistrement selon la revendication 1, utilisé pour mettre en œuvre une fonction de type contrôle du direct.

17. Procédé d'enregistrement selon la revendication 1, utilisé pour mettre en œuvre une fonction de vidéo-surveillance.

18. Boîtier décodeur comprenant des moyens de traitement agencés pour mettre en œuvre le procédé d'enregistrement selon l'une des revendications précédentes.

19. Programme d'ordinateur comprenant des instructions pour mettre en œuvre, par un équipement de type boîtier décodeur, le procédé d'enregistrement selon l'une des revendications 1 à 17.

20. Moyens de stockage, **caractérisés en ce qu'**ils stockent un programme d'ordinateur comprenant des instructions pour mettre en œuvre, par un équipement de type boîtier décodeur, le procédé d'enregistrement selon l'une des revendications 1 à 17.

## Patentansprüche

1. Verfahren zur Aufzeichnung eines empfangenen Datenstroms, wie z. B. eines Audio- und/oder Videodatenstroms, wobei das Aufzeichnungsverfahren die Schritte umfasst:
- Evaluieren einer Abnutzung eines Speichermediums, das dazu bestimmt ist, den empfangenen Datenstrom aufzuzeichnen, wobei die Evaluierung der Abnutzung den Schritt des Erfassens eines Abnutzungsparameters in dem Speichermedium umfasst, der repräsentativ für die Abnutzung des Speichermediums ist;
- in Abhängigkeit von der Abnutzung, Berechnen einer optimalen Datenstromrate, die ein Erhöhen der Lebensdauer des Speichermediums ermöglicht, wobei die optimale Datenstromrate eine Rate ist, die geringer oder gleich der Rate des empfangenen Datenstroms ist, wodurch gleichzeitig eine Qualität einer zeitversetzten Ausstrahlung eines ausgestrahlten Programms und eine Reduzierung der Abnutzung des Speichermediums optimiert werden kann;
- Anpassen des empfangen Datenstroms, um ihn mit der optimalen Datenstromrate aufzuzeichnen.

2. Verfahren zur Aufzeichnung nach Anspruch 1, ferner umfassend den Schritt des Anpassens des Abnutzungsparameters, damit er eine tatsächliche Abnutzung des Speichermediums besser charakterisiert.

3. Verfahren zur Aufzeichnung nach Anspruch 1, bei dem der Abnutzungsparameter ein Abnutzungsgrad zwischen 0 und 1 oder zwischen 0 und 100% ist.

4. Verfahren zur Aufzeichnung nach Anspruch 1, bei dem der Abnutzungsparameter eine Anzahl von Schreib-/Löschzyklen ist.

5. Verfahren zur Aufzeichnung nach Anspruch 1, bei dem die optimale Datenstromrate gleich der Rate des empfangen Datenstroms ist, wenn die Abnutzung des Speichermediums geringer oder gleich einem vorbestimmten Abnutzungsschwellenwert ist, und gleich der Rate des empfangenen Datenstroms ist, multipliziert mit einem vorbestimmten Begrenzungsverhältnis, wenn die Abnutzung des Speichermediums größer als ein vorbestimmter Abnutzungsschwellenwert ist, wobei das vorbestimmte Begrenzungsverhältnis zwischen 0 und 1 liegt.

6. Verfahren zur Aufzeichnung nach Anspruch 1, bei dem die optimale Datenstromrate eine lineare Funktion der Abnutzung des Speichermediums ist.

7. Verfahren zur Aufzeichnung nach Anspruch 1, bei dem die optimale Datenstromrate eine lineare Funktion der Abnutzung des Speichermediums ist, bis diese einen vorbestimmten Abnutzungsschwellenwert erreicht.

8. Verfahren zur Aufzeichnung nach Anspruch 1, bei dem die Anpassung des empfangenen Datenstroms darin besteht, eine Rate des empfangenen Datenstroms anzupassen, damit die Rate des empfangenen Datenstroms und folglich des aufgezeichneten Datenstroms gleich der optimalen Datenstromrate ist.

9. Verfahren zur Aufzeichnung nach Anspruch 8, bei dem die Anpassung der Rate des empfangenen Datenstroms darin besteht, einem externen Server, der den Datenstrom erzeugt, eine Zielrate vorzugeben.

10. Verfahren zur Aufzeichnung nach Anspruch 9, bei dem die Zielrate gleich der optimalen Datenstromrate ist, wenn diese niedriger oder gleich einer maximalen Übertragungsrate eines Netzes ist, auf dem der empfangene Datenstrom fließt, und bei dem die Zielrate gleich der maximalen Übertragungsrate des Netzes ist, wenn die optimale Datenstromrate größer als die maximale Übertragungsrate des Netzes ist.

11. Verfahren zur Aufzeichnung nach Anspruch 1, bei dem die Anpassung des empfangenen Datenstroms darin besteht, den empfangenen Datenstrom umzukodieren, um den aufgezeichneten Datenstrom zu erhalten.

12. Verfahren zur Aufzeichnung nach Anspruch 11, bei dem die Umkodierung darin besteht, auf einen Audiodatenstrom, der in dem empfangenen Datenstrom enthalten ist, einzuwirken.

13. Verfahren zur Aufzeichnung nach Anspruch 12, bei dem die Einwirkung auf den Audiodatenstrom darin besteht, eine Audiospur, die einer nicht gewünschten Sprache entspricht, zu unterdrücken und/oder eine Anzahl von Audiospurkanälen zu verringern und/oder eine Kompressionsrate eines Codecs anzupassen und/oder einen verwendeten Codex zu modifizieren.

14. Verfahren zur Aufzeichnung nach Anspruch 11, bei dem die Umkodierung darin besteht, auf einen Videodatenstrom, der in dem empfangenen Datenstrom enthalten ist, einzuwirken.

15. Verfahren zur Aufzeichnung nach Anspruch 14, bei dem die Einwirkung auf den Videodatenstrom darin besteht, die Auflösung der Bilder des Videodatenstroms zu verringern und/oder eine Kompressionsrate eines Codecs anzupassen und/oder einen verwendeten Codec zu modifizieren.

16. Verfahren zur Aufzeichnung nach Anspruch 1, das verwendet wird, um eine Funktion vom Typ zeitversetztes Fernsehen auszuführen.

17. Verfahren zur Aufzeichnung nach Anspruch 1, das verwendet wird, um eine Videoüberwachungsfunktion auszuführen.

18. Set-Top-Box, umfassend Verarbeitungsmittel, die ausgebildet sind, um das Verfahren zur Aufzeichnung nach einem der vorhergehenden Ansprüche auszuführen.

19. Computerprogramm, das Anweisungen umfasst, um durch eine Ausrüstung vom Typ Set-Top-Box das Verfahren zur Aufzeichnung nach einem der Ansprüche 1 bis 17 durchzuführen.

20. Speichermittel, die **dadurch gekennzeichnet sind, dass** sie ein Computerprogramm speichern, das Anweisungen zum Durchführen des Verfahrens zur Aufzeichnung nach einem der Ansprüche 1 bis 17 durch eine Ausrüstung vom Typ Set-Top-Box umfasst.

## Claims

1. A recording method for recording a received stream such as an audio and/or video stream, the recording method comprising the steps:
- of evaluating wear of a storage medium for recording the received stream, the wear being evaluated by acquiring, from the storage medium, a wear parameter that is representative of the wear of the storage medium;
- of calculating, as a function of the wear, an optimum stream data rate for increasing the lifetime of the storage medium, the optimum stream data rate being a data rate that is less than or equal to the data rate of the received stream, and that allows to optimize both the quality of the time-shifted playback of the broadcast program and to reduce the wear of the storage medium;
- of adapting the received stream so as to record it at the optimum stream data rate.

2. A recording method according to claim 1, further comprising a step of adapting the wear parameter so that it better characterizes real wear of the storage medium.

3. A recording method according to claim 1, wherein the wear parameter is a degree of wear lying in the range 0 to 1 or in the range 0 to 100%.

4. A recording method according to claim 1, wherein the wear parameter is a number of write/delete cycles.

5. A recording method according to claim 1, wherein the optimum stream data rate is equal to the data rate of the received stream when the wear of the storage medium is less than or equal to a predetermined wear threshold, and is equal to the data rate of the received stream multiplied by a predetermined limiting ratio when the wear of the storage medium is greater than the predetermined wear threshold, the predetermined limiting ratio lying in the range 0 to 1.

6. A recording method according to claim 1, wherein the optimum stream data rate is a linear function of the wear of the storage medium.

7. A recording method according to claim 1, wherein the optimum stream data rate is a linear function of the wear of the storage medium until the wear reaches a predetermined wear threshold.

8. A recording method according to claim 1, wherein the received stream is adapted by adjusting a data rate of the received stream so that the data rate of the received stream, and thus of the recorded stream, is equal to the optimum stream data rate.

9. A recording method according to claim 8, wherein the data rate of the received stream is adjusted by specifying a target data rate to an external server that generates the stream.

10. A recording method according to claim 9, wherein the target data rate is equal to the optimum stream data rate when that data rate is less than or equal to a maximum transfer data rate of a network over which the received stream passes, and wherein the target data rate is equal to the maximum transfer data rate of the network when the optimum stream data rate is greater than the maximum transfer data rate of the network.

11. A recording method according to claim 1, wherein the received stream is adapted by transcoding the received stream in order to obtain the recorded stream.

12. A recording method according to claim 1, wherein the transcoding consists in acting on an audio stream contained in the received stream.

13. A recording method according to claim 12, wherein the action on the audio stream consists in eliminating an audio track corresponding to a language that is not desired, and/or in reducing the number of channels in the audio tracks, and/or in adjusting a compression ratio of a codec, and/or in changing the codec being used.

14. A recording method according to claim 11, wherein the transcoding consists in acting on a video stream contained in the received stream.

15. A recording method according to claim 14, wherein the action on the video stream consists in reducing the resolution of images in the video stream, and/or in adjusting the compression ratio of a codec, and/or in changing the codec in use.

16. A recording method according to claim 1, used for performing a time-shifting type function.

17. A recording method according to claim 1, used for performing a video surveillance function.

18. A set-top box including processor means arranged to perform the recording method according to any preceding claim.

19. A computer program including instructions for enabling equipment of the set-top box type to perform the recording method according to any one of claims 1 to 17.

20. Storage means, **characterized in that** they store a computer program containing instructions for enabling equipment of the set-top box type to perform the recording method according to any one of claims 1 to 17.
